(19)

Europäisches
Patentamt
European
Patent Office
Office européen
des brevets

(11) **EP 2 621 121 A2**

(12) **EUROPEAN PATENT APPLICATION**

(43) Date of publication:
**31.07.2013 Bulletin 2013/31**

(51) Int Cl.:
*H04L 1/00* *(2006.01)*

(21) Application number: **13000406.2**

(22) Date of filing: **28.01.2013**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **30.01.2012 US 201261592202 P
10.04.2012 US 201261622223 P
11.05.2012 US 201261646037 P
26.09.2012 US 201261706045 P
25.01.2013 US 201313750280**

(71) Applicant: **Broadcom Corporation
Irvine, CA 92617 (US)**

(72) Inventors:
• **Stauffer, Erik
Mountain View, CA 94040 (US)**
• **Tujkovic, Djordje
Mountain View, CA 94040 (US)**

• **Blanksby, Andrew
Lake Oswego, CA 97034 (US)**
• **Chakraborty, Soumen
560103 Bangalore (IN)**
• **Shen, Bazhong
Irvine, CA 92620 (US)**
• **Garrett, David
Tustin, CA 92782 (US)**
• **Rath, Kamlesh
San Ramon, CA 94582 (US)**
• **Huang, Jing
Irvine, CA 92617 (US)**
• **Shet, Shiv
600042 Chennai (IN)**

(74) Representative: **Jehle, Volker Armin
Bosch Jehle Patentanwaltsgesellschaft mbH
Flüggenstrasse 13
80639 München (DE)**

(54) **Supercharged codes**

(57)     A system and method is provided for encoding k input symbols into a longer stream of n output symbols for transmission over an erasure channel such that the original k input symbols can be recovered from a subset of the n output symbols without the need for any retransmission. A symbol is a generic data unit, consisting of one or more bits, that can be, for example, a packet. The system and method utilize a network of erasure codes, including block codes and parallel filter codes to achieve performance very close to the ideal MDS code with low encoding and decoding computational complexity for both small and large encoding block sizes. This network of erasure codes is referred to as a supercharged code. The supercharged code can be used to provide packet-level protection at, for example, the network, application, or transport layers of the Internet protocol suite.

**FIG. 1**

EP 2 621 121 A2

**Description**

Cross Reference to Related Applications

This application claims the benefit of U.S. Provisional Patent Application No. 61/592,202, filed January 30, 2012, U.S. Provisional Patent Application No. 61/622,223, filed April 10, 2012, U.S. Provisional Patent Application No. 61/646,037, filed May 11, 2012, and U.S. Provisional Patent Application No. 61/706,045, filed September 26, 2012, all of which are incorporated herein by reference.

Technical Field

This application relates generally to coding of symbols for transmission over an erasure channel and, more particularly, to coding of packets for transmission over a packet erasure channel.

Background

The packet erasure channel is a communication channel model where transmitted packets are either received or lost, and the location of any lost packet is known. The Internet usually can be modeled as a packet erasure channel. This is because packets transmitted over the Internet can be lost due to corruption or congestion, and the location of any lost packet can be inferred from a sequence number included in a header or payload of each received packet.
Depending on the type of data carried by a stream of packets, a lost packet can reduce the quality of the data or even render the data unusable at a receiver. Therefore, recovery schemes are typically used to provide some level of reliability that packets transmitted over an erasure channel will be received. For example, retransmission schemes are used to recover lost packets in many packet-based networks, but retransmissions can result in long delays when, for example, there is a large distance between the transmitter and receiver or when the channel is heavily impaired. For this reason and others, forward error correction (FEC) using an erasure code is often implemented in place of, or in conjunction with, conventional retransmission schemes.
An erasure code encodes a stream of $k$ packets into a longer stream of $n$ packets such that the original stream of $k$ packets can be recovered at a receiver from a subset of the $n$ packets without the need for any retransmission. The performance of an erasure code can be characterized based on its reception efficiency and the computational complexity associated with its encoding and decoding algorithms. The reception efficiency of an erasure code is given by the fraction $k'/k$, where $k'$ is the minimum number of the $n$ packets that need to be received in order to recover the original stream of $k$ packets. Certain erasure codes have optimal reception efficiency (i.e., the highest obtainable reception efficiency) and can recover the original stream of $k$ packets using any (and only) $k$ packets out of the n packets transmitted. Such codes are said to be maximum distance separable (MDS) codes.
The Reed-Solomon code is an MDS code with optimal reception efficiency, but the typical encoding and decoding algorithms used to implement the Reed-Solomon code have high associated computational complexities. Specifically, their computational complexities grow with the number of packets $n$ and are of the order $O(n\log(n))$. This makes a pure Reed-Solomon solution impractical for many packet-based networks, including the Internet, that support the transmission of large files/streams segmented into many, potentially large, packets.

BRIEF SUMMARY OF THE INVENTION

According to an aspect, a method is provided for erasure coding of input symbols that form messages, comprising:

    implementing at least three block coding operations that respectively provide a first, second, and third set of code words based on the messages;
    implementing at least two filter coding operations that respectively provide a fourth and fifth set of code words based on the first set of code words;
    modifying an order in which bits of the first set of code words are taken into account for at least one of the two filter coding operations; and
    parallel concatenating the second, third, fourth, and fifth sets of code words to form encoded symbols for transmission over an erasure channel.

Advantageously, the method further comprises:

    implementing a repetition coding operation that respectively repeats the second and third sets of code words some number of times before the second and third sets of code words are parallel concatenated with the fourth and fifth sets of code words.

Advantageously, the second, third, fourth, and fifth sets of code words are parallel concatenated using an exclusive or operation.

Advantageously, the method further comprises:

multiplexing the fourth and fifth sets of code words together in an irregular manner before parallel concatenating the second, third, fourth, and fifth sets of code words.

Advantageously, the one of the block coding operations that provides the first set of code words implements a binary block code.

Advantageously, the one of the block coding operations that provides the second set of code words implements a non-binary block code over a finite field.

Advantageously, the non-binary block code is a Reed-Solomon block code.

Advantageously, the one of the block coding operations that provides the third set of code words implements a binary block code.

Advantageously, at least one of the two filter coding operations uses a tailbiting filter.

According to an aspect, an encoder is provided for erasure coding of input symbols that form messages, comprising:

three block coding modules configured to respectively provide a first, second, and third set of code words based on the messages;
two filter coding modules configured to respectively provide a fourth and fifth set of code words based on the first set of code words;
an interleaver configured to modify an order in which bits of the first set of code words are taken into account for at least one of the two filter coding modules; and
a concatenation module configured to parallel concatenate the second, third, fourth, and fifth sets of code words to form encoded symbols for transmission over an erasure channel.

Advantageously, the encoder further comprises:

a repetition coding module configured to repeat the second and third sets of code words some number of times before the second and third sets of code words are parallel concatenated with the fourth and fifth sets of code words by the concatenation module.

Advantageously, the encoder further comprises:

a multiplexer configured to multiplex the fourth and fifth sets of code words together in an irregular manner before the second, third, fourth, and fifth sets of code words are parallel concatenated by the concatenation module.

Advantageously, the one of the three block coding modules configured to provide the second set of code words implements a non-binary block code over a finite field.

Advantageously, the non-binary block code is a Reed-Solomon block code.

Advantageously, at least one of the two filter coding modules comprises a tailbiting filter.

Advantageously, at least one of the two filter coding modules comprises a finite impulse response (FIR) filter.

Advantageously, the concatenation module implements an exclusive or operation.

Advantageously, the encoder is implemented in a desktop computer, a laptop computer, a tablet computer, a mobile phone, a set-top box, or a router.

According to an aspect, an encoder is provided for erasure coding of input symbols that form messages, comprising:

a block coding module configured to provide a first set of code words based on the messages;
two filter coding modules separated by an interleaver and configured to respectively provide a second and third set of code words based on the messages; and
a concatenation module configured to parallel concatenate the first, second, and third sets of code words to form encoded symbols for transmission over an erasure channel.

According to an aspect, a decoder comprises:

a processor; and
a memory,
wherein the processor is configured to decode symbols encoded by:

implementing a block coding operation to provide a first set of code words based on messages formed by the symbols;
implementing at least two filter coding operations, separated by an interleaver, to provide a second and third set of code words based on the messages; and
concatenating the first, second, and third sets of code words.

Brief Description of the Drawings/Figures

The accompanying drawings, which are incorporated herein and form a part of the specification, illustrate the embodiments of the present disclosure and, together with the description, further serve to explain the principles of the embodiments and to enable a person skilled in the pertinent art to make and use the embodiments.

FIG. 1 illustrates a block diagram of an encoder implementing the supercharged code in accordance with embodiments of the present disclosure.

FIG. 2 illustrates an example parallel filter coding module that can be used by an encoder implementing the supercharged code in accordance with embodiments of the present disclosure.

FIG. 3 illustrates an example finite impulse response (FIR) filter that can be used by a parallel filter code in accordance with embodiments of the present disclosure.

FIG. 4 illustrates an encoder with the same implementation of the encoder in FIG. 1, with the exception of an additional systematic pre-processing module, in accordance with embodiments of the present disclosure.

FIG. 5 illustrates a block diagram of an example computer system that can be used to implement aspects of the present disclosure.

The embodiments of the present disclosure will be described with reference to the accompanying drawings. The drawing in which an element first appears is typically indicated by the leftmost digit(s) in the corresponding reference number.

Detailed Description

In the following description, numerous specific details are set forth in order to provide a thorough understanding of the embodiments of the present disclosure. However, it will be apparent to those skilled in the art that the embodiments, including structures, systems, and methods, may be practiced without these specific details. The description and representation herein are the common means used by those experienced or skilled in the art to most effectively convey the substance of their work to others skilled in the art. In other instances, well-known methods, procedures, components, and circuitry have not been described in detail to avoid unnecessarily obscuring aspects of the invention.

References in the specification to "one embodiment," "an embodiment," "an example embodiment," etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to affect such feature, structure, or characteristic in connection with other embodiments whether or not explicitly described.

**1. Overview**

The present disclosure is directed to a system and method for encoding $k$ input symbols into a longer stream of $n$ output symbols for transmission over an erasure channel such that the original $k$ input symbols can be recovered from a subset of the $n$ output symbols without the need for any retransmission. A symbol is a generic data unit, consisting of one or more bits, that can be, for example, a packet. The system and method of the present disclosure utilize a network of erasure codes, including block codes and parallel filter codes to achieve performance very close to the ideal MDS code with low encoding and decoding computational complexity for both small and large values of $n$. This network of erasure codes is referred to as a supercharged code.

## 2. Supercharged Code

### 2.1. Encoder

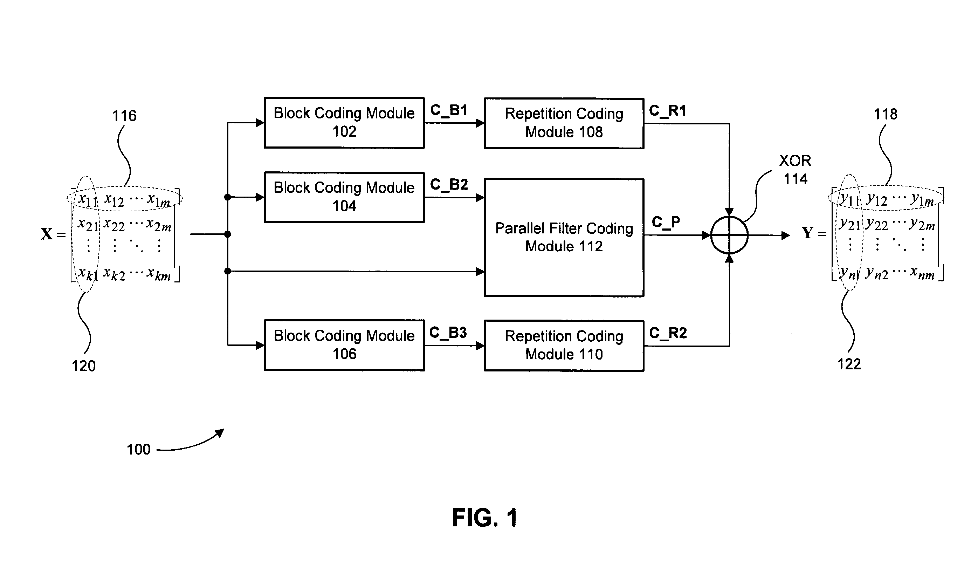

FIG. 1 illustrates a block diagram of an encoder 100 implementing the supercharged code in accordance with embodiments of the present disclosure. Encoder 100 can be implemented in hardware, software, or any combination thereof to encode a matrix **X** of $k$ input symbols into a longer length matrix **Y** of $n$ output symbols for transmission over an erasure channel such that the original $k$ input symbols can be recovered from a subset of the $n$ output symbols without the need for any retransmission.

Each row of bits in matrix **X** forms a different one of the $k$ input symbols, and each row in **Y** forms a different one of the $n$ output symbols. For example, the first row of bits 116 in matrix **X** forms a first one of the $k$ input symbols in matrix **X**, and the first row of bits 118 in matrix **Y** forms a first of the $n$ output symbols in matrix **Y**. In addition, each column of bits in matrix **X** forms what is referred to as a message, and each corresponding column of bits in matrix **Y** forms what is referred to as a code word of the message. For example, the first column of bits 120 in matrix **X** forms one message, and the first column of bits 122 in matrix **Y** forms a code word of the message. Subsequent, corresponding columns of bits in matrices **X** and **Y** form additional pairs of messages and code words.

It should be noted that each coding module in encoder 100 (to be described below) receives a matrix of input symbols/messages and generates a matrix of output symbols/code words of the same general form described above in regard to matrices **X** and **Y**. In some instances, the coding modules in encoder 100 are placed in series, such that the matrix of output symbols/code words generated by one coding module represent the matrix of input symbols/messages received by another coding module in encoder 100. The terms input symbols, output symbols, messages, and code words are used in a consistent manner throughout the disclosure below to describe these matrices.

As shown in FIG. 1, the encoder 100 is constructed from a network of coding modules, including block coding modules 102, 104, and 106, repetition coding modules 108 and 110, and parallel filter coding module 112. In general, the output code words generated by block coding modules 102, 104, and 106 are informative and provide high reception efficiencies but are complex to decode, whereas the output code words generated by parallel filter coding module 112 are comparatively easier to decode but not as informative. Thus, encoder 100 uses repetition coding modules 108 and 110 to respectively repeat shorter-length output code words generated by block coding modules 102 and 106 and then parallel concatenates them, using exclusive or (XOR) operation 114 (or some other concatenation module such as a multiplexer or an XOR operating over a non-binary finite field), with longer-length output code words generated by parallel filter coding module 112 to produce a series of $n$ supercharged encoded output symbols. This network of coding modules can achieve performance very close to the ideal MDS code with low encoding and decoding computational complexity for both small and large encoding block sizes (i.e., for both small and large values of $k$). It should be noted that in other embodiments of encoder 100, one of the two block coding modules 102 and 106, and/or block coding module 104, and/or the direct input of matrix **X** into parallel filter coding module 112 can be omitted.

In one embodiment of encoder 100, block coding module 102 implements a binary linear block code that accepts as input the $k$ input symbols in matrix **X** and generates $n\_b1$ output symbols through the linear mapping:

$$\mathbf{C\_B1}=\mathbf{G\_B1}*\mathbf{X} \qquad (1)$$

where **C_B1** is a matrix of the $n\_b1$ output symbols and **G_B1** is an $n\_b1 \times k$ generator matrix. Each column of bits in matrix **X** forms a message, and each corresponding column of bits in matrix **C_B1** forms a code word of the message. The code words can take on $2^{n\_b1}$ possible values corresponding to all possible combinations of the $n\_b1$ binary bits. However, the binary linear block code implemented by block coding module 102 uses $2^k$ code words from the $2^{n\_b1}$ possibilities to form the code, where each $k$ bit message is uniquely mapped to one of these $2^k$ code words using generator matrix **G_B1**. In general, any unique subset of $2^k$ code words, selected from the $2^{n\_b1}$ possibilities, that provides sufficiently easy to decode outputs with sufficient error correction capabilities for a given application can be used to implement block coding module 102.

In another embodiment of encoder 100, block coding module 104 similarly implements a binary linear block code that accepts as input the $k$ input symbols in matrix **X** and generates $n\_b2$ output symbols through the linear mapping:

$$\mathbf{C\_B2}=\mathbf{G\_B2}*\mathbf{X} \qquad (2)$$

where **C_B2** is a matrix of the $n\_b2$ output symbols and **G_B2** is an $n\_b1 \times k$ generator matrix. Each column of bits in matrix **X** forms a message, and each corresponding column of bits in matrix **C_B2** forms a code word of the message. The code words can take on $2^{n\_b2}$ possible values corresponding to all possible combinations of the $n\_b2$ binary bits. However, the binary linear block code implemented by block coding module 104 uses $2^k$ code words from the $2^{n\_b2}$ possibilities to form the code, where each $k$ bit message is uniquely mapped to one of these $2^k$ code words using generator matrix **G_B2**. In general, any unique subset of $2^k$ code words, selected from the $2^{n\_b2}$ possibilities, that provides sufficiently easy to decode outputs with sufficient error correction capabilities for a given application can be used to implement block coding module 104.

In yet another embodiment of encoder 100, block coding module 106 implements a non-systematic Reed Solomon code that accepts as input the $k$ input symbols in matrix **X** and generates $n\_b3$ output symbols through the linear mapping:

$$\mathbf{C\_B3} = \mathbf{G\_B3} * \mathbf{X} \qquad\qquad (3)$$

where **C_B3** is a matrix of the $n\_b3$ output symbols and **G_B3** is a $n\_b3 \times k$ Vandermonde generator matrix. The non-systematic Reed Solomon code can be implemented by block coding module 106 over the finite field GF(256). It should be noted that block coding module 106 can implement other non-binary block codes, including those not constructed over finite fields, in other embodiments. For example, in other embodiments, block coding module 106 can implement a systematic (as opposed to a non-systematic) Reed Solomon code or another type of cyclic block code.

In yet another embodiment of encoder 100, parallel filter coding module 112 accepts as input the $n\_b2$ symbols in matrix **C_B2** and generates a longer length $n\_p$ matrix of output symbols **C_P** using a linear block code formed by the parallel concatenation of at least two constituent filter or convolution codes separated by an interleaver. The at least two constituent filter or convolution codes can be the same or different.

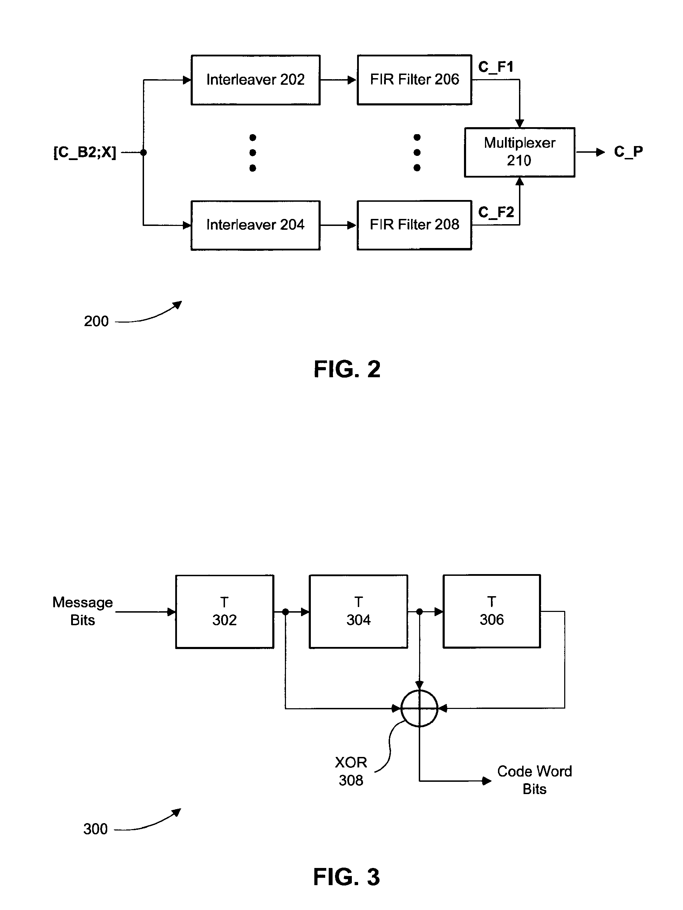

A block diagram of an example parallel filter coding module 200 is illustrated in FIG. 2 in accordance with embodiments of the present disclosure. As shown, parallel filter coding module 200 includes interleavers 202 and 204, finite impulse response (FIR) filters 206 and 208, and multiplexer 210. Interleavers 202 and 204 each receive and process the messages in matrix **C_B2.** Interleaver 202 rearranges the order of the bits in each message in matrix **C_B2** in an irregular but prescribed manner, and interleaver 204 rearranges the order of the bits in each message in matrix **C_B2** in an irregular but prescribed manner that is different from the irregular manner implemented by interleaver 202. Because FIR filters 206 and 208 receive the bits of the messages in matrix **C_B2** in different, respective orders, the code words in matrix **C_F1** generated by FIR filter 206 will almost always be different than the code words in matrix **C_F2** generated by FIR filter 208, even when the two filters are identically implemented.

It should be noted that in other embodiments of parallel filter coding module 200, it may be possible to feed the message of matrix **C_B2** into one of FIR filters 206 and 208 without first interleaving. It should be further noted that more than two interleavers and FIR filters can be implemented by parallel filter coding module 200. Specifically, one or more additional pairs of interleavers and FIR filters can be added to parallel filter coding module 200. In addition, it should be further noted that FIR filters 206 and 208 can be implemented as tailbiting FIR filters, where the states of FIR filters 206 and 208 are initialized with their respective final states to make them tailbiting.

In general, a good linear code is one that uses mostly high-weight code words (where the weight of a code word, also known as its Hamming weight, is simply the number of ones that it contains) because they can be distinguished more easily by the decoder. While all linear codes have some low weight code words, the occurrence of these low weight code words should be minimized. Interleavers 202 and 204 help to reduce the number of low-weight code words generated by parallel filter coding module 200, where the weight of a code word generated by parallel filter coding module 200 is generally the sum of the weights of corresponding code words generated by FIR filters 206 and 208. More specifically, because the bits of the respective message inputs to FIR filters 206 and 208 have been reordered in different, irregular manners by interleavers 202 and 204, the probability that both FIR filters 206 and 208 simultaneously produce corresponding code words of low-weight is reduced. Thus, interleavers 202 and 204 help to reduce the number of low-weight code words generated by parallel filter coding module 200.

As further shown in FIG. 2, the code words in matrices **C_F1** and **C_F2** are parallel concatenated using multiplexer 210 to generate the code words in matrix **C_P.** In one embodiment, multiplexer 210 parallel concatenates the code words in matrices **C_F1** and **C_F2** in an irregular but prescribed manner.

FIG. 3 illustrates an example FIR filter 300 that can be used to implement one or both of FIR filters 206 and 208 in FIG. 2 in accordance with embodiments of the present disclosure. As shown in FIG. 3, bits from a message of matrix **C_B2** enter FIR filter 300 from the left and are stored in a linear shift register comprising registers 302, 304, and 306 (T denotes a register). Each time a new message bit arrives, the message bits in registers 302, 304, and 306 are shifted to the right. FIR filter 300 computes each bit of the code word corresponding to the input message by exclusive or-ing a particular subset of the message bits stored in the shift register and, possibly, the current message bit at the input of the shift register. In the embodiment of FIR filter 300 shown in FIG. 3, the code word bits are specifically computed by exclusive or-ing each message bit stored in the shift register using XOR operation 308.

The constraint length of FIR filter 300 is defined as the maximum number of message bits that a code word bit can depend on. In the embodiment of FIR filter 300 shown in FIG. 3, the constraint length is four because each code word bit can depend on up to four message bits (the three message bits in the shift register and the current message bit at the input of the shift register). It should be noted that in other embodiments of FIR filter 300, a different constraint length can be used, and the code word bits can be computed by exclusive or-ing a different subset of the message bits stored in the shift register.

Referring back to FIG. 1, in yet another embodiment of encoder 100, repetition coding module 108 implements a binary linear block code that accepts as input the $n\_b1$ symbols in matrix **C_B1** and generates a longer length $n$ matrix of output symbols **C_R1** through the linear mapping:

$$C\_R1 = G\_R1 * C\_B1 \qquad (4)$$

where **G_R1** is an $n \times n\_b1$ generator matrix. In at least one embodiment, the repetition code described by the generator matrix **G_R1** is designed to simply repeat the code words in **C_B1** some number of times (either some integer or integer plus fractional number of times) such that the length $n\_b1$ code words in **C_B1** are transformed into longer length $n$ code words in **C_R1**. Specifically, the generator matrix **G_R1** can be implemented as an $n \times n\_b1$ stack of identity matrices, with floor($n/n\_b1$) copies of the identity matrix stacked vertically and a fractional identity matrix below that includes $n$ mod $n\_b1$ rows.

In yet another embodiment of encoder 100, repetition coding module 110 implements a binary linear block code that accepts as input the $n\_b3$ symbols in matrix **C_B3** and generates a longer length $n$ matrix of output symbols **C_R2** through the linear mapping:

$$C\_R2 = G\_R2 * C\_B3 \qquad (5)$$

where **G_R2** is an $n \times n\_b3$ generator matrix. In at least one embodiment, the repetition code described by the generator matrix **G_R2** is designed to simply repeat the code words in **C_B3** some number of times (either some integer or integer plus fractional number of times) such that the length $n\_b3$ code words in **C_B3** are transformed into length $n$ code words in **C_R2**. Specifically, the generator matrix **G_R2** can be implemented as an $n \times n\_b3$ stack of identity matrices, with floor($n/n\_b3$) copies of the identity matrix stacked vertically and a fractional identity matrix below that includes $n$ mod $n\_b3$ rows.

As described above, encoder 100 can be used to provide packet-level protection at various layers of a network architecture. For example, encoder 100 can be used to provide packet-level protection at the network, application, or transport layers of the Internet protocol suite, commonly known as TCP/IP. In one embodiment, encoder 100 is used at a server or client computer (e.g., a desktop computer, laptop computer, tablet computer, smart phone, router, set-top-box, or other portable communication devices) to encode $k$ packets, segments, or datagrams of data formatted in accordance with some protocol, such as the File Delivery over Unidirectional Transport (FLUTE) protocol, for transmission to another computer over a packet based network, such as the Internet.

### 2.2. Matrix Representation

Because all of the constituent block coding modules in encoder 100 are, in at least one embodiment, linear modules, the output matrix Y can be expressed through the linear mapping:

$$Y = G\_S * X \qquad (6)$$

where the generator matrix **G_S** describes the generic supercharged code implemented by encoder 100. The generator matrix **G_S** is specifically given by:

$$G\_S = G\_P*[I\_k; G\_B2] + G\_R1*G\_B1 + G\_R2*G\_B3 \qquad (7)$$

where **G_P** is the $n \times (k+n\_b2)$ generator matrix of parallel filter coding module 112, **I_k** is a $k \times k$ identity matrix, **G_ B2** is the $n\_b2 \times k$ generator matrix of block coding module 104, **G_R1** is the $n \times n\_b1$ generator matrix of repetition coding module 108, **G_B1** is the $n\_b1 \times k$ generator matrix of block coding module 102, **G_R2** is the $n \times n\_b3$ generator matrix of repetition coding module 110, and **G_B3** is the $n\_b3 \times k$ generator matrix of block coding module 106. The notation [**A**; **B**] used above in equation (7) denotes the vertical stack of matrix **A** on **B**, and the operator '+' used above in equation (7) denotes the bitwise XOR operation.

### 2.3. Systematic Encoding

The supercharged code is not an inherently systematic code. Nonsystematic codes are commonly transformed into an effective systematic code by pre-processing input data **D** before using it as the input to the encoder, **Y**= **G_S*X**. The encoder input **X** is calculated by decoding the desired input data **D** to be encoded and running the decoder to determine the encoder input vector **X**. Let matrix **G_S_ENC** be the $k \times k$ generator matrix corresponding to the first $k$ elements of each code word in **Y**, the encoder input **X** can be computed using the following:

$$X = G\_S\_ENC^{\wedge\wedge}(-1) * D \qquad (8)$$

where the operation **G_S_ENC^^(-1)** raises **G_S_ENC** to the power (-1). Now, **X** can be used to encode using equation (6) to generate **Y,** and the first $k$ elements of each code word in **Y** will be equal to **D**.

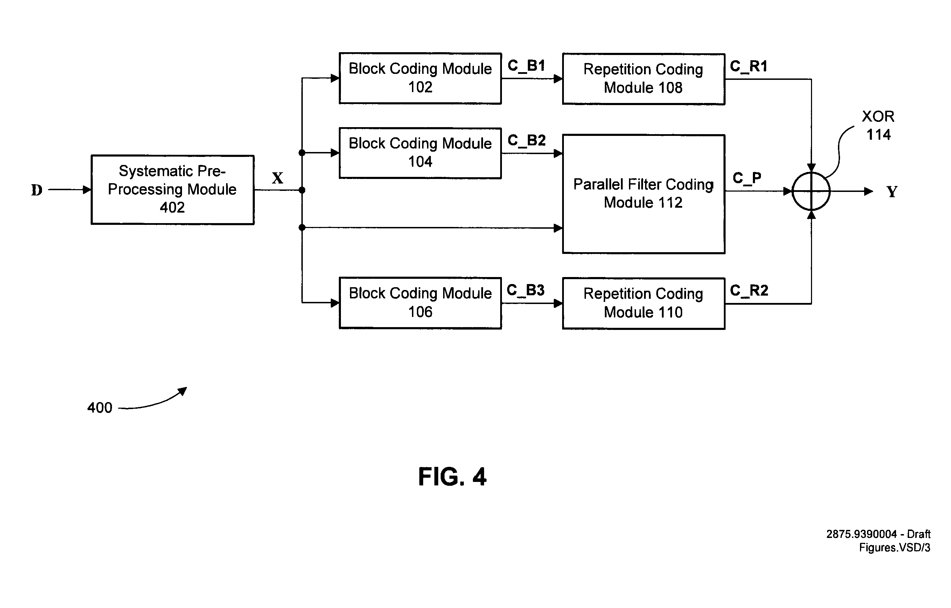

FIG. 4 illustrates an encoder with the same implementation as encoder 100 in FIG. 1, with the exception of an additional systematic pre-processing module 402, in accordance with embodiments of the present disclosure. Systematic pre-processing module 402 can be sued to perform the function defined by equation 8 and can be implemented in hardware, software, or any combination thereof.

### 2.4. Segmentation of Files for Encoding

Before encoder 100 can be used to encode, for example, a source file for transmission over an erasure channel, the source file needs to be segmented into encoder input symbols and those encoder input symbols need to be grouped into source blocks that can be represented by the input matrix **X** to encoder 100 as shown in FIG. 1. Specifically, given a source file of $f$ bytes and an encoder input symbol size of $t$ bytes, the file can be divided into $k\_total$ = ceil($f/t$) encoder input symbols. A source block is a collection of $kl$ or $ks$ of these encoder input symbols. $kl$ and $ks$ may be different if the total number source blocks does not evenly divide the number of encoder input symbols required to represent the source file. The number of source blocks with $kl$ encoder input symbols and the number of source block with $ks$ encoder input symbols can be communicated to the decoder. In one embodiment, the source blocks are ordered such that the first $zl$ source blocks are encoded from source blocks of size $kl$ encoder input symbols, and the remaining $zs$ source blocks are encoded from source block of size $ks$ encoder input symbols.
In one embodiment, $kl$ is chosen under the constraint that the selected value of $kl$ is less than or equal to at least one of a finite number of possible values for the number of input symbols $k$ in the matrix **X** that encoder 100 in FIG. 1 accepts as input. Assuming that $kl$ is chosen to meet this constraint, then encoder 100 can be implemented, in at least one embodiment, to accept an input matrix **X** with the smallest number of input symbols $k$ that still satisfies the (non-strict) inequality $kl \leq k$.

### 2.5 Erasure Channel

After encoding, the $n$ output symbols of matrix **Y** are transmitted on the channel. Some of these output symbols are erased by the channel. Suppose that the $n \times r$ matrix **E** represents the erasure pattern of the channel in that it selects out the $r$ received output symbols **Y_R** from the transmitted output symbols **Y**. If the $i$th received symbol is the $j$th transmit symbol, then **E**($i,j$)=1. This results in

$$Y\_R = E*Y \qquad\qquad (9)$$

At the decoder, the effective generator matrix at the receiver is then **G_S_R = E*G_S.**

**2.6 Decoding**

Decoding is the process of determining **X** given **Y_R** and **G_S_R.** Decoding can be implemented in several different ways, but each are equivalent to solving the least squares problem **X = (G_S_R^^T*G_S_R)^^-1 * G_S_R^^T * Y_R,** where T denotes the transpose. Modem sparse matrix factorization techniques can be used to take advantage of the sparse structure imposed by the structure of parallel filter coding module 112 in FIG. 1 with (6) rewritten in appropriate form:

$$\mathbf{Z} = \mathbf{G\_A*W} \qquad\qquad (10)$$

with augmented generator matrix **G_A** defined as:

$$\mathbf{G\_A} = [[[\mathbf{G\_B1}; \mathbf{G\_B3}; \mathbf{GB\_2}] \,|\, \mathbf{I\_L}]; [\mathbf{G\_P} \,|\, \mathbf{G\_R1} \,|\, \mathbf{G\_R2}]] \qquad (11)$$

and where the augmented output vector **Z**=[zeros(L,1); **Y**], the augmented input vector **W=[X; G_B2*X; G_B1*X; G_B3*X]**, and where L= $n\_b1+n\_b2+b\_b3$. The bottom L elements of matrix **W** contain the outputs, before repetition, of the block codes. These L values are appended to matrix **X** to form the augmented input matrix **W**. The first L rows of **G_A** implement the block code and XOR the block code output with itself to generate the L zeros at the top of the matrix **Z**. The subsequent $n$ rows of **G_A** implement the FIR structure and XOR the output with the output of the block codes. The notation [**A**; **B**] used above in equation (11) denotes the vertical stack of matrices **A** on **B**, and the notation **A | B** denotes the horizontal concatenation of matrices **A** and **B**.

Once the encoder state matrix **X**, or equivalently the augmented encoder state matrix **W**, has been determined, the task remains to determine the data matrix **D**. For any symbols of **D** that are missing, they can be recovered by using appropriate rows of (6) or (10).

**3. Example Computer System Implementation**

It will be apparent to persons skilled in the relevant art(s) that various elements and features of the present invention, as described herein, can be implemented in hardware using analog and/or digital circuits, in software, through the execution of instructions by one or more general purpose or special-purpose processors, or as a combination of hardware and software.

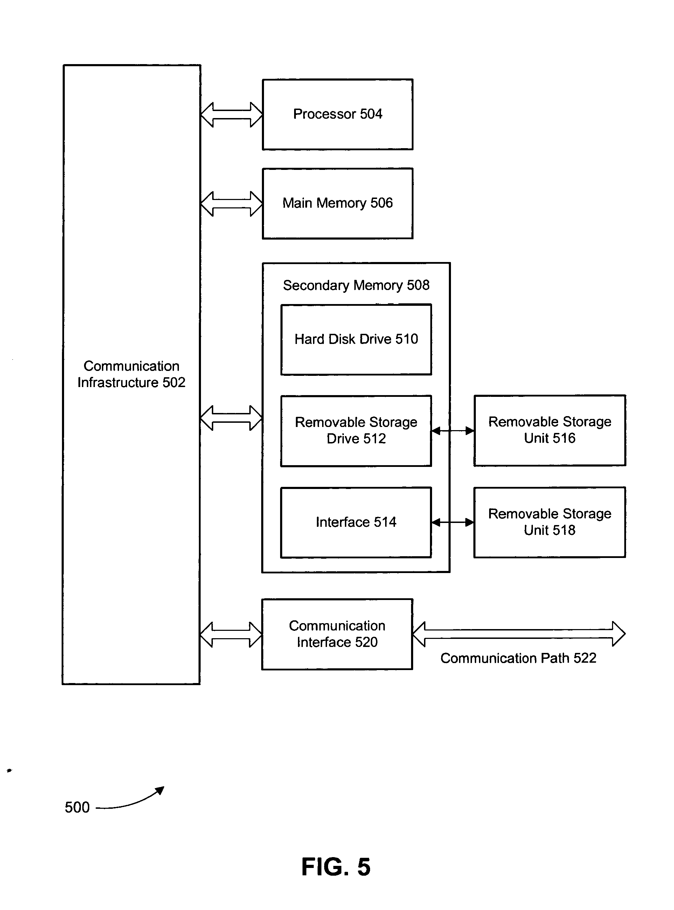

The following description of a general purpose computer system is provided for the sake of completeness. Embodiments of the present invention can be implemented in hardware, or as a combination of software and hardware. Consequently, embodiments of the invention may be implemented in the environment of a computer system or other processing system. An example of such a computer system 500 is shown in FIG. 5. All of the modules depicted in FIGS. 1 and 4, for example, can execute on one or more distinct computer systems 500.

Computer system 500 includes one or more processors, such as processor 504. Processor 504 can be a special purpose or a general purpose digital signal processor. Processor 504 can be connected to a communication infrastructure 502 (for example, a bus or network). Various software implementations are described in terms of this exemplary computer system. After reading this description, it will become apparent to a person skilled in the relevant art(s) how to implement the invention using other computer systems and/or computer architectures.

Computer system 500 also includes a main memory 506, preferably random access memory (RAM), and may also include a secondary memory 508. Secondary memory 508 may include, for example, a hard disk drive 510 and/or a removable storage drive 512, representing a floppy disk drive, a magnetic tape drive, an optical disk drive, or the like. Removable storage drive 512 reads from and/or writes to a removable storage unit 516 in a well-known manner. Removable storage unit 516 represents a floppy disk, magnetic tape, optical disk, or the like, which is read by and written to by removable storage drive 512. As will be appreciated by persons skilled in the relevant art(s), removable storage unit 516 includes a computer usable storage medium having stored therein computer software and/or data.

In alternative implementations, secondary memory 508 may include other similar means for allowing computer programs or other instructions to be loaded into computer system 500. Such means may include, for example, a removable storage unit 518 and an interface 514. Examples of such means may include a program cartridge and cartridge interface (such as that found in video game devices), a removable memory chip (such as an EPROM, or PROM) and associated socket, a thumb drive and USB port, and other removable storage units 518 and interfaces 514 which allow software and data to be transferred from removable storage unit 518 to computer system 500.

Computer system 500 may also include a communications interface 520. Communications interface 520 allows software and data to be transferred between computer system 500 and external devices. Examples of communications interface 520 may include a modem, a network interface (such as an Ethernet card), a communications port, a PCMCIA slot and card, etc. Software and data transferred via communications interface 520 are in the form of signals which may be electronic, electromagnetic, optical, or other signals capable of being received by communications interface 520. These signals are provided to communications interface 520 via a communications path 522. Communications path 522 carries signals and may be implemented using wire or cable, fiber optics, a phone line, a cellular phone link, an RF link and other communications channels.

As used herein, the terms "computer program medium" and "computer readable medium" are used to generally refer to tangible storage media such as removable storage units 516 and 518 or a hard disk installed in hard disk drive 510. These computer program products are means for providing software to computer system 500.

Computer programs (also called computer control logic) are stored in main memory 506 and/or secondary memory 508. Computer programs may also be received via communications interface 520. Such computer programs, when executed, enable the computer system 500 to implement the present invention as discussed herein. In particular, the computer programs, when executed, enable processor 504 to implement the processes of the present invention, such as any of the methods described herein. Accordingly, such computer programs represent controllers of the computer system 500. Where the invention is implemented using software, the software may be stored in a computer program product and loaded into computer system 500 using removable storage drive 512, interface 514, or communications interface 520.

In another embodiment, features of the invention are implemented primarily in hardware using, for example, hardware components such as application-specific integrated circuits (ASICs) and gate arrays. Implementation of a hardware state machine so as to perform the functions described herein will also be apparent to persons skilled in the relevant art(s).

## 4. Conclusion

The present disclosure has been described above with the aid of functional building blocks illustrating the implementation of specified functions and relationships thereof. The boundaries of these functional building blocks have been arbitrarily defined herein for the convenience of the description. Alternate boundaries can be defined so long as the specified functions and relationships thereof are appropriately performed.

**Claims**

1. A method for erasure coding of input symbols that form messages, comprising:

    implementing at least three block coding operations that respectively provide a first, second, and third set of code words based on the messages;
    implementing at least two filter coding operations that respectively provide a fourth and fifth set of code words based on the first set of code words;
    modifying an order in which bits of the first set of code words are taken into account for at least one of the two filter coding operations; and
    parallel concatenating the second, third, fourth, and fifth sets of code words to form encoded symbols for transmission over an erasure channel.

2. The method of claim 1, further comprising:

    implementing a repetition coding operation that respectively repeats the second and third sets of code words some number of times before the second and third sets of code words are parallel concatenated with the fourth and fifth sets of code words.

3. The method of claim 1 or 2, wherein the second, third, fourth, and fifth sets of code words are parallel concatenated using an exclusive or operation.

4. The method of any preceding claim, further comprising:

    multiplexing the fourth and fifth sets of code words together in an irregular manner before parallel concatenating the second, third, fourth, and fifth sets of code words.

5. The method of any preceding claim, wherein the one of the block coding operations that provides the first set of code words implements a binary block code.

6. The method of any preceding claim, wherein the one of the block coding operations that provides the second set of code words implements a non-binary block code over a finite field.

7. The method of claim 6, wherein the non-binary block code is a Reed-Solomon block code.

8. The method of any preceding claim, wherein the one of the block coding operations that provides the third set of code words implements a binary block code.

9. The method of any preceding claim, wherein at least one of the two filter coding operations uses a tailbiting filter.

10. An encoder for erasure coding of input symbols that form messages, comprising:

    three block coding modules configured to respectively provide a first, second, and third set of code words based on the messages;
    two filter coding modules configured to respectively provide a fourth and fifth set of code words based on the first set of code words;
    an interleaver configured to modify an order in which bits of the first set of code words are taken into account for at least one of the two filter coding modules; and
    a concatenation module configured to parallel concatenate the second, third, fourth, and fifth sets of code words to form encoded symbols for transmission over an erasure channel.

11. The encoder of claim 10, further comprising:

    a repetition coding module configured to repeat the second and third sets of code words some number of times before the second and third sets of code words are parallel concatenated with the fourth and fifth sets of code words by the concatenation module.

12. The encoder of claim 10 or 11, further comprising:

    a multiplexer configured to multiplex the fourth and fifth sets of code words together in an irregular manner before the second, third, fourth, and fifth sets of code words are parallel concatenated by the concatenation module.

13. The encoder of any of the claims 10 to 12, wherein the one of the three block coding modules configured to provide the second set of code words implements a non-binary block code over a finite field.

14. An encoder for erasure coding of input symbols that form messages, comprising:

    a block coding module configured to provide a first set of code words based on the messages;
    two filter coding modules separated by an interleaver and configured to respectively provide a second and third set of code words based on the messages; and
    a concatenation module configured to parallel concatenate the first, second, and third sets of code words to form encoded symbols for transmission over an erasure channel.

15. A decoder comprising:

    a processor; and
    a memory,

wherein the processor is configured to decode symbols encoded by:

implementing a block coding operation to provide a first set of code words based on messages formed by the symbols;
implementing at least two filter coding operations, separated by an interleaver, to provide a second and third set of code words based on the messages; and
concatenating the first, second, and third sets of code words.

116

$$X = \begin{bmatrix} x_{11} & x_{12} \cdots x_{1m} \\ x_{21} & x_{22} \cdots x_{2m} \\ \vdots & \vdots \ddots \vdots \\ x_{k1} & x_{k2} \cdots x_{km} \end{bmatrix}$$

120

| Block Coding Module 102 | **C_B1** | Repetition Coding Module 108 | **C_R1** |

| Block Coding Module 104 | **C_B2** |

Parallel Filter Coding Module 112 **C_P**

| Block Coding Module 106 | **C_B3** | Repetition Coding Module 110 | **C_R2** |

XOR
114

118

$$Y = \begin{bmatrix} y_{11} & y_{12} \cdots y_{1m} \\ y_{21} & y_{22} \cdots y_{2m} \\ \vdots & \vdots \ddots \vdots \\ y_{n1} & y_{n2} \cdots x_{nm} \end{bmatrix}$$

122

100

**FIG. 1**

**FIG. 2**

**FIG. 3**

```
                                    ┌──────────────────┐  C_B1  ┌──────────────────┐  C_R1
                                    │ Block Coding Module│──────▶│ Repetition Coding │────────┐
                                    │        102         │        │    Module 108     │         │
                                    └──────────────────┘        └──────────────────┘         │
                                                                                              │
                                    ┌──────────────────┐  C_B2  ┌──────────────────┐          │    XOR
                                    │ Block Coding Module│──────▶│                  │          │    114
     ┌──────────────────┐           │        104         │       │                  │          │
D ──▶│ Systematic Pre-  │    X      └──────────────────┘       │ Parallel Filter    │  C_P     │
     │ Processing Module│───────▶                              │ Coding Module 112  │────────▶ ⊕ ──▶ Y
     │       402        │         ───────────────────────────▶│                    │          │
     └──────────────────┘                                      └──────────────────┘          │
                                    ┌──────────────────┐  C_B3  ┌──────────────────┐  C_R2    │
                                    │ Block Coding Module│──────▶│ Repetition Coding │─────────┘
                                    │        106         │        │    Module 110     │
                                    └──────────────────┘        └──────────────────┘
```

400

# FIG. 4

2875.9390004 - Draft
Figures.VSD/3

FIG. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 61592202 A
- US 61622223 A
- US 61646037 A
- US 61706045 A